# EUROPEAN PATENT SPECIFICATION

(11) **EP 3 189 546 B1**
(45) Date of publication and mention of the grant of the patent: **04.04.2018**
(21) Application number: 15763225.8
(22) Date of filing: 27.08.2015
(51) Int. Cl.: H01L 25/075, B60Q 1/32, H01L 33/56

(54) **A METHOD OF APPLYING A LIGHTING ARRANGEMENT TO A SURFACE AND A LIGHTING SURFACE**
VERFAHREN ZUM AUFBRINGEN EINER BELEUCHTUNGSANLAGE AUF EINER OBERFLÄCHE UND EINER LEUCHTFLÄCHE
PROCÉDÉ D'APPLICATION D'UN AGENCEMENT D'ÉCLAIRAGE SUR UNE SURFACE ET UNE SURFACE D'ÉCLAIRAGE

(30) Priority: 02.09.2014 EP 14183139
(43) Date of publication of application: 12.07.2017
(73) Proprietor: Philips Lighting Holding B.V., 5656 AE Eindhoven (NL)
(72) Inventor: JACOBS, Egbertus Reinier, NL-5656 AE Eindhoven (NL); DE SAMBER, Marc Andre, NL-5656 AE Eindhoven (NL); VAN GRUNSVEN, Eric Cornelis Egbertus, NL-5656 AE Eindhoven (NL); JANSSEN, Esther Anna Wilhelmina Gerarda, NL-5656 AE Eindhoven (NL)
(74) Representative: Verweij, Petronella Daniëlle
(86) International application number: PCT/EP2015/069652
(87) International publication number: WO 2016/034492

(56) References cited:
- WO-A1-2009/075924
- WO-A2-2008/091319
- DE-A1-102012 101 160
- DE-U1-202014 102 938
- US-A1- 2008 224 153
- US-A1- 2011 193 105
- US-A1- 2012 228 666

## Description

### FIELD OF THE INVENTION

The invention relates to a method of applying a lighting arrangement to a surface and to a surface coating including lighting elements.

### BACKGROUND OF THE INVENTION

LED lighting is transforming the lighting industry, such that lighting products are no longer merely on/off devices, but have become sophisticated devices with more elaborate control options, made possible by the easy controllability of LEDs.

LED lighting also offers the possibility of very versatile designs from an aesthetic point of view.

For example, LED lighting can be used to provide illumination from a surface, giving an even greater range of possible applications.

One area of interest is in automotive lighting. The visual appearance of vehicle side lights and signaling lights is a significant design feature. There are many different examples of the use of LEDs within vehicle lights, but the known examples are all visible in the off state, as they are formed as separate units to be fitted at suitable locations within the car body.

There is therefore a desire for a lighting system in which a light output can be provided from a surface, with the LED light sources not visible or barely visible to the eye when turned off. This desire applies to automobile applications, but it also applies to other painted surfaces, where the aesthetic quality of the painted surface should not be compromised by the inclusion of lighting functionality. Document WO 2008/091319 A2 relates to methods for wafer level encapsulation of light emitting diodes within a wavelength conversion layer.

Document DE 10 2012 101160 A1 relates to a light source module with a shield that is arranged between adjacent semiconductor chips and is opaque to emitted radiation to reduce optical crosstalk between semiconductor chips.

Document WO 2009/075924 A1 relates to a light assembly for vehicle comprising LED chips embedded in a transparent polymer layer which is coated with a paint layer.

### SUMMARY OF THE INVENTION

The invention is defined by the claims.

According to an aspect of the invention, there is provided a method of applying a lighting arrangement to surface, comprising:
forming a first conductive layer over the surface, the conductive layer being for connection to a first electrical terminal;
applying an array of LED lighting elements over the first conductive layer, each comprising a pad with top and bottom electrical contacts, wherein the top contact comprises a projecting contact bump, wherein the LED lighting elements are applied such that at least a fraction thereof are upwardly facing with their top contacts facing away from the surface;
spray paint coating to fill the spaces between the LED lighting elements and cover the LED lighting elements with sprayed paint;
removing a top portion of the sprayed paint thereby to reveal the contact bumps for the upwardly facing LED lighting elements and to form light output windows for the upwardly facing LED lighting elements; and
forming a second conductive layer over the sprayed paint and the revealed contact bumps, the second conductive layer being for connection to a second electrical terminal.

This method provides LED lighting elements embedded in a sprayed paint material. This enables the functional parts of the lighting elements to be substantially invisible in the off state, only becoming visible in the on state. This enables the flexibility to apply light emitting devices to odd shaped surfaces.

The degree to which the lighting elements are made invisible can be controlled by selecting the amount of the top portion of the sprayed paint to be removed. For example, the size of a light output window can be controlled by the design of the LED lighting elements, so that a desired trade-off can be found between the size of the light output openings in the paint layer, and the light output intensity.

The step of removing a top portion of the sprayed paint not only reveals the contact bumps for the upwardly facing LED lighting elements, but it also opens an optical light output window. This window may comprise the contact bumps themselves, or it may comprise a separate light output region of the LED lighting elements.

There may be applications in which the light output is for providing information rather than for illuminating a scene. For example, designs can give additional safety, by giving a hot or cold indication relating to a surface or object.

The method steps can all be standard process steps such as spraying and sanding, which are for example used in the automotive field. The lighting elements themselves are specifically designed for the method.

The ability to provide invisible light sources in a surface coating is very attractive from a design perspective.

Preferably, the first conductive layer is sprayed. It may for example comprise silver filled epoxy.

The lighting elements are designed so that they can be applied easily with the correct orientation.

For example, the LED lighting elements may have a ratio of the square root of the pad area to the pad thickness which is more than 2, for example more than 3, for example more than 4. This means they can easily be applied so that they are arranged with their electrical contacts at the top and bottom. They may for example be applied by a random deposition process. In this case, some lighting elements will be the right way up (with top contacts facing away from the surface) and others will be the wrong way up. However, as a result of the diode characteristics, these will simply not function, and a desired light output can be ensured from the correctly oriented lighting elements.

By way of example, the LED lighting elements may have an area less than 10000(µm)² and a thickness less than 50µm.

If desired, it may be ensured that the lighting elements are all oriented in the desired way.

The LED lighting elements may be applied while the first conductive layer is tacky. In this way, no additional steps are needed to ensure the lighting elements are held in place during the subsequent method steps.

The LED lighting elements may for example be applied by particle blasting, jetting or foil transfer.

The step of removing a top portion may comprise sanding. This is a standard process step used in the coating surfaces, such as spray coating methods. Forming the second conductive layer may comprise spraying a transparent conductive layer. A transparent protective coating is preferably also applied over the second conductive layer.

In one example the conductor layers are continuous, so that all the lighting elements are connected in parallel. However, alternatively, the first conductor layer may be patterned to define separately addressable regions. In this way, different regions can be operated independently.

The surface may comprise a surface of an automobile body panel. In this way, the invention enables the integration of lighting elements into the paintwork of an automobile. This lighting can replace discrete light units, such as side lights or signalling lights. The method steps can all be compatible with standard steps used in applying car paint.

Another aspect of the invention provides a surface coated with a lighting arrangement, comprising:
a first conductive layer over the surface, the first conductive layer being connected to a first electrical terminal;
an array of LED lighting elements over the first conductive layer, each comprising a pad with top and bottom electrical contacts, wherein at least a fraction of the LED lighting elements are upwardly facing with their top contacts facing away from the surface;
a spray paint coating which fills the spaces between the LED lighting elements, and partially covers the LED lighting elements but with contacts of the upwardly facing LED lighting elements exposed and with light output windows formed in the spray paint coating for the upwardly facing LED lighting elements; and
a second conductive layer over the spray paint coating and the exposed contacts, the second conductive layer being connected to a second electrical terminal.

The LED lighting elements may have a ratio of the square root of the pad area to the pad thickness which is more than 2, for example more than 3, for example more than 4; and/or the LED lighting elements have an area less than 10000(µm)² and a thickness less than 50µm.

The LED elements may comprise an optical output cover over the top contact. Since the spray paint coating is not transparent, no light guiding can take place within or across this spray coating. The output cover then provides any desired beam shaping or redirection that may be desired, for example to reduce the visibility of the individual lighting elements, which function as point sources. The output cover then gives options to convert the light output.

### BRIEF DESCRIPTION OF THE DRAWINGS

Examples of the invention will now be described in detail with reference to the accompanying drawings, in which:
Figure 1 shows a first example of LED element for use in a coating method, and for use as part of a coated surface;
Figure 2 shows a second example of LED element for use in a coating method, and for use as part of a coated surface;
Figure 3 shows the LED element of Figure 2 used within a coating;
Figure 4 shows the different stages in a coating method;
Figure 5 shows the electrical circuit of the lighting elements within a coating; and
Figure 6 shows the steps of the coating method as a flowchart.

### DETAILED DESCRIPTION OF THE EMBODIMENTS

The invention provides a method of applying a lighting arrangement to a surface in which LED lighting elements are provided over a first conductive layer, each comprising a pad with top and bottom electrical contacts. A spray paint coating fills the spaces between the LED lighting elements. It also initially covers the LED lighting elements until a top portion of the sprayed paint material is removed to reveal the LED top contact. A second conductive layer is formed over the sprayed paint material and the revealed top contacts, the second conductive layer being connected to a second electrical terminal.

The paint comprises an opaque reflective material for providing a desired aesthetic appearance to the surface, such as the colour and reflective properties. It is desired that the lighting arrangement detracts as little as possible from this aesthetic appearance.

The coating method can use standard deposition and layer processing steps. The LED lighting elements are designed to be suitable for the method.

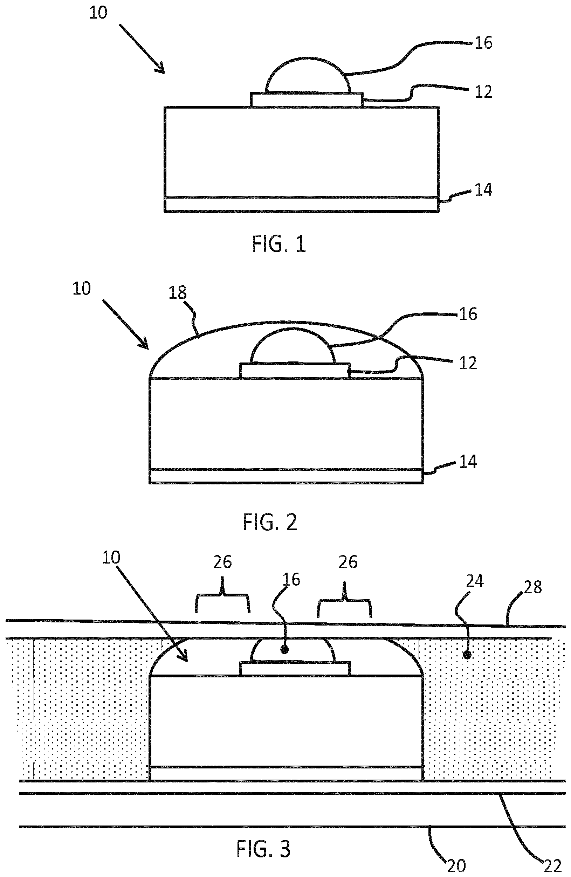

Figure 1 shows a first example of an LED lighting element for use in a coating method, and for use as part of a coated surface.

The lighting element 10 comprises a discrete LED package with a top electrical contact 12 and a bottom electrical contact 14. The top contact 12 comprises a projecting contact bump 16.

The lighting element is in the form of a very small LED, for example with a footprint of <100 µm x <100 µm, or an area less than 10000(µm)². The footprint may be square or rectangular or indeed any other shape. The thickness is for example <50 µm.

For some deposition processes, such as application by spraying or other application in a jet form, an important feature of the shape is that it should resist standing on its edges, so that even if the lighting element is placed randomly on a surface, it will lie with the contacts 12,14 facing up and down.

One way to achieve this is to make the lighting element pad shaped, i.e. with a relatively large area compared to the thickness. For example, the LED lighting elements may have a ratio of the square root of the pad area (i.e. the effective linear dimension of the pad area) to the pad thickness which is more than 2, for example more than 3, for example more than 4.

Another possible way to prevent the lighting element to stand on edge is to have angled side walls, so that the lighting element is unstable on its edges. The lighting elements are diced from a wafer, and the dicing lines can be scored at an angle. For example, a double-sided wafer dicing process can be used with a V-groove dicing saw. This can be used to provide V-shaped edges so that they are unstable when balanced on the tip/edge of the V shape.

The lighting elements may have a shape which is designed in dependence on the orientation of the surface to which they will be applied. For example, for application to a vertical surface, a large aspect ratio may be sufficient, in that gravity will topple an element standing on its edge. For a horizontal surface, a design which is only stable on its front and back faces may be preferred so that it cannot stand upright on its edge.

For other deposition processes, such as application by transfer from a carrier foil, the orientation can be controlled precisely.

The LED lighting element can be entirely conventional, apart from the use of the contact bump 16 which is used to provide an electrical interconnect (as described below). For this reason, the manufacture and design of the LED lighting element will not be described in further detail. One of the electrical contacts is an anode contact to the LED and the other is a cathode contact to the LED.

Figure 2 shows a second example of an LED element for use in a coating method, and for use as part of a coated surface. It has the same structure as in Figure 1 but has an additional optical output cover 18 over the top contact 16, in the form of a transparent casing.

As will be described below, the LED element is covered by a paint film as part of the deposition process. This film may block the optical path if the LED element is embedded in such an opaque paint film. If the LED element of Figure 1 is completely covered with a paint film, and sanded back until the contact 16 is revealed, the LED light output surface may still be covered with the non-transparent film.

This may not cause a problem if the contact 16 itself is transparent (for example formed from ITO), as it can then define a light escape window. However, the transparent casing 18 of the design of Figure 2 provides an optical output path which may be larger and which enables an opaque metal to be used for the contact 16..

It will be well understood by the skilled person that other possibilities exist for ensuring an optical output path to the LED element, such as, by way of non-limiting examples, further sanding back the paint film over the light exit window regions of the elements after deposition, or for example electrostatically charging light exit regions (or non-light exit regions) so as to ensure paint deposition only on certain portions of the array of lighting elements. In these, and many other possible examples, thus, the simpler design of Figure 1 can be used. However, the design of Figure 2 provides one particularly efficient means by which an opaque paint spray coating may be applied to LED lighting elements, while still ensuring an optical output path from each LED element, and enabling otherwise standard LED elements to be used.

The contact 16 and the transparent casing if desired can be applied at the wafer level during manufacture of the LED lighting elements.

Figure 3 shows how the LED lighting element of Figure 2 is used. The LED lighting element 10 is applied over a surface 20 to which a conductive coating 22 has been applied. The lower contact 14 of the LED lighting element electrically connects to the conductive coating 22.

A spray paint coating 24 fills the spaces between the LED lighting elements (only one lighting element is shown in Figure 3), and partially covers the LED lighting elements. The top contact 16 is exposed by sanding back the spray paint coating. This sanding process also removes the top of the transparent casing 18 to form an optical output window 26.

A second conductive layer 28 is provided over the top and makes electrical contact with the exposed contacts 16.

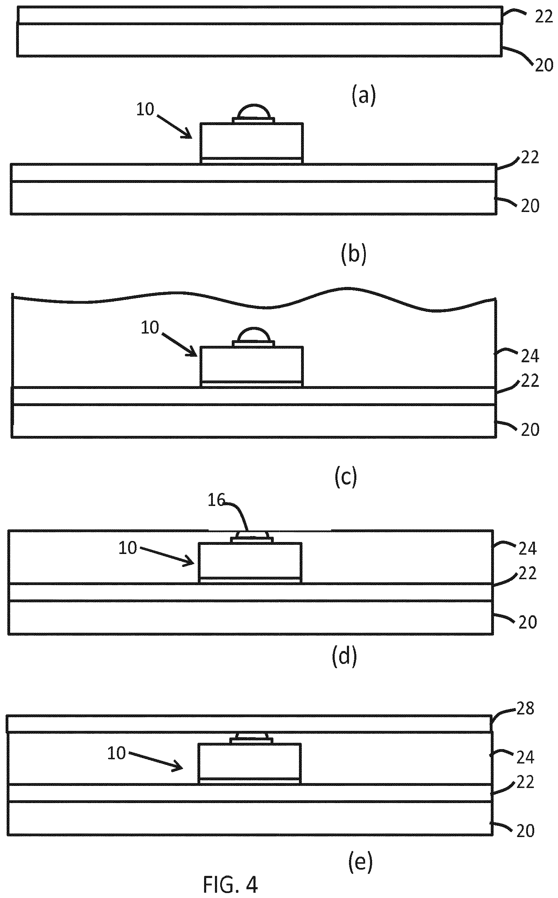

The method of forming the coated surface will now be explained with reference to Figure 4.

Figure 4(a) shows a first step of applying a conductor layer 22 to a carrier surface 20. The carrier surface 20 may typically comprise a metal and/or a polymer. The conductor layer 22 may for example be sprayed. The conductor layer requires a low resistivity, and one example is a silver-filled epoxy layer. Spray coating is of course a standard procedure in the automotive industry and is preferred for automotive applications. However, other application methods may be used such as roll coating, knife blading, dip coating or dispense coating.

Figure 4(b) shows the second step of applying the LED lighting elements 10. Only one lighting element is shown, but an array will be deposited, with a density selected in dependence on the desired lighting effect. The lighting elements 10 are as described above. The LED lighting elements are designed to ensure a proper connection to the electrically conductive layer 20 as well as a top layer to be applied later in the process. The top contact is designed for this purpose, for example in the form of a stud bump which can be sanded back to open the electrical contact. Note that Figure 4 shows the LED lighting element of Figure 1, which requires a transparent contact 16 when an opaque paint is sprayed. Of course the lighting elements with an optical output cover may instead be used.

As explained above, the LED preparation may also modify the shape or composition in such way that the LEDs will (or preferentially will) be facing-up after application. This design is tailored to the application method.

In a random application process, it will be difficult to ensure the LED lighting elements can only land on one side, although it is possible to ensure they do not land on edge. The packages might also land upside down. Upside down packages do not contribute to the optical output (since the LED diode will be connected in reverse), and these lighting elements will also not hamper the system electrically. LED lighting elements which are on edge could short circuit the system and thus they do need to be prevented. As explained above, a suitable aspect ratio can be used to prevent the LEDs landing on their edges.

Thus, the lighting elements are applied such that at least a fraction thereof are upwardly facing with their top contacts facing away from the surface. Some deposition techniques can ensure that this fraction is 1, whereas a random deposition technique may only achieve a fraction of 0.5.

The LED lighting elements are applied to the conductive layer 22 while it is still tacky. Several processes can be used to distribute the LEDs on the tacky conductive layer. As the LEDs have to make good electrical contact to the bottom electrode, it is not possible to immerse them into the paint. Suitable random methods are particle blasting (wherein the LED lighting elements are the particles) or jetting. A controlled method is for example a foil transfer method.

Figure 4(c) shows the step of embedding the LED lighting elements in car paint 24. The layer thickness must be at least as thick as the LED lighting elements 10 in order to be able to open the contacts. The process used for this is a regular spray coating process.

Figure 4(d) shows the result of applying a sanding process. Sanding is a standard process in the automotive paint application, when layers are cured and the next layer needs to be applied. When the spraying process is performed correctly, opening the contacts and the optical path can be performed by a sanding process. During this step, the layer is thinned until the top electrical contacts 16 are revealed. An optical output window is also defined.

The transparent top conductor 28 is then applied as shown in Figure 4(e), which makes electrical connection to the opened contacts 16. This layer is transparent to allow light to couple out.

To be compatible with car paint and car-body materials like ABS (Acrylonitrile Butadiene Styrene) the process for applying the top conducting layer is temperature limited.

To protect all layers and the LED lighting elements the total assembly can be finished with a clear coat finish (not shown in the drawings).

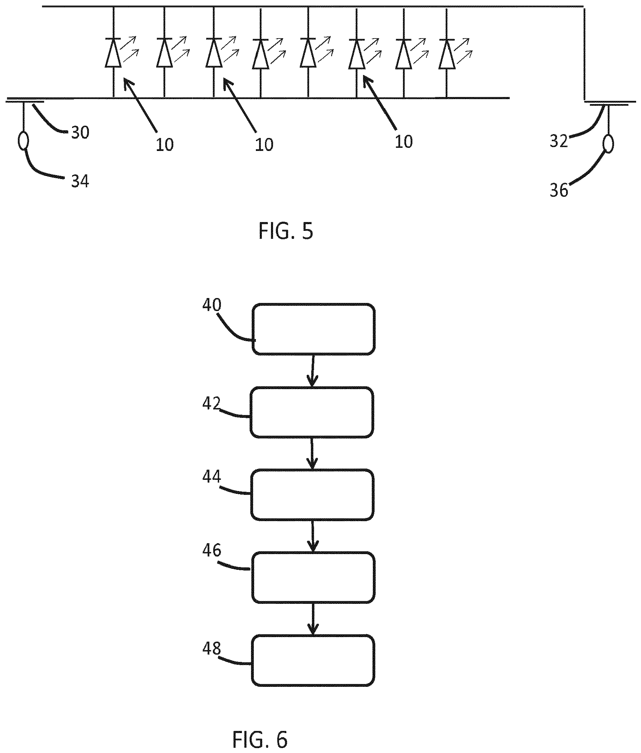

Figure 5 shows the electrical circuit formed. If there is a single continuous first conductive layer 22 and a single continuous second conductive layer 28, then all LED lighting elements 10 will be in parallel as shown.

The top and bottom connections to the first and second conductive layers 22,28 can be made by spraying each conductive layer over an electrically isolated metal connection. These connections are shown in Figure 5 as contact pads 30,32. The car wiring then connects to these contact pads, as represented by terminals 34,36. These connection areas can be placed at a hidden region, can be made through the body panel.

The first conductor layer 22 may be patterned to define separately addressable regions. A spray masking process can be used for this purpose. Separate lighting regions can be actuated using separate power connections. This allows for instance to distinguish between braking lights, indicator lights, etc. on the same body panel.

The method is shown as a flow chart in Figure 6.

The method comprises the step of:
step 40: forming the first conductive layer over the surface;
step 42: applying the array of LED lighting elements over the first conductive layer;
step 44: spray paint coating to fill the spaces between the LED lighting elements and cover the LED lighting elements with sprayed paint material;
step 46: removing a top portion of the sprayed paint material thereby to reveal the contact bumps; and
step 48: forming a second conductive layer (and optionally a further protective layer) over the sprayed paint material and the revealed contact bumps.

The top electrically conductive layer may form a ground connection, and in such a case, the protective layer may not be required, as the transparent conductive layer may itself have the required protective properties, of course depending on the particular application.

The density of the lighting elements will be selected according to the desired lighting effect. For example, the lighting elements may occupy a fraction of an area where they are applied.

The area to be occupied by the lighting elements will depend on the density of the luminous surface which is desired. For signal lighting, a small area may be desired with a dense concentration of lighting elements, such as in the range of 5 to 25 packages per cm². For a highlighting design feature, a slightly less dense package over a larger area may be desired. For example, there could be around 1 - 10 lighting elements per cm². When an overall sparkling effect is desired, the number of packages can drop even further. The number of lighting elements may then be between 0.1 and 1 packages per cm².

The luminous output per lighting element for low power LEDs will typically be around 15 lumen, and for example in the range from 1 to 30 lumen. If an output of 15 lumen is considered to be the luminous output, the output for a dense concentration may for example be 200 lm/cm² for signal lighting (around 13 packages per cm²) and 8 lm/cm2 for an overall sparkling effect (around 0.5 packages per cm²).

As will be clear from the description above, one application of particular interest is automotive body panels. In this case, the surface comprises an automobile body panel and the paint comprises automobile paint. There are numerous conceivable advantageous applications for lighting arrangements applied to automotive body panel surfaces.

Safety can for example be increased by adding LED lighting elements in the paint on the side of a car. Subtle lighting can also be used to highlight design features, and it gives a design department more freedom in the placement of signal lighting.

Besides the automotive application, many other products can be provided with a painted lighting layer. The lighting surface can for example provide feedback to a user about the state of a system, such as cold/hot, ready/not ready, on/off, etc.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A method of applying a lighting arrangement to a surface, comprising:
forming a first conductive layer (22) over the surface (20), the conductive layer being for connection to a first electrical terminal;
applying an array of LED lighting elements (10) over the first conductive layer, each comprising a pad with top and bottom electrical contacts (12,14), wherein the top contact comprises a projecting contact bump (16), wherein the LED lighting elements (10) are applied such that at least a fraction thereof are upwardly facing with their top contacts (12,16) facing away from the surface;
spray paint coating to fill the spaces between the LED lighting elements and cover the LED lighting elements with sprayed paint (24);
removing a top portion of the sprayed paint (24) thereby to reveal the contact bumps (16) for the upwardly facing LED lighting elements and to form light output windows for the upwardly facing LED lighting elements; and
forming a second conductive layer (28) over the sprayed paint and the revealed contact bumps, the second conductive layer being for connection to a second electrical terminal.

2. A method as claimed in claim 1, wherein the first conductive layer (22) is sprayed.

3. A method as claimed in any preceding claim, wherein:
the LED lighting elements (10) have a ratio of the square root of the pad area to the pad thickness which is more than 2, for example more than 3, for example more than 4; and/or
the LED lighting elements (10) have an area less than 10000(µm)² and a thickness less than 50µm.

4. A method as claimed in any preceding claim, wherein the LED lighting elements (10) are applied while the first conductive layer (22) is tacky.

5. A method as claimed in any preceding claim, wherein the LED lighting elements (10) are applied by particle blasting, jetting or foil transfer.

6. A method as claimed in any preceding claim, wherein removing a top portion comprises sanding.

7. A method as claimed in any preceding claim, wherein forming the second conductive layer (28) comprises spraying a transparent conductive layer.

8. A method as claimed in any preceding claim, further comprising applying a transparent protective coating over the second conductive layer.

9. A method as claimed in any preceding claim, wherein the first conductor layer (22) is patterned to define separately addressable regions.

10. A method as claimed in any preceding claim, wherein the surface (20) comprises an automobile body panel.

11. A surface coated with a lighting arrangement, comprising:
a first conductive layer (22) over the surface (20), the first conductive layer (22) being for connection to a first electrical terminal (34);
an array of LED lighting elements (10) over the first conductive layer (22), each comprising a pad with top and bottom electrical contacts (12,14), wherein at least a fraction of the LED lighting elements (10) are upwardly facing with their top contacts (12,16) facing away from the surface;
a spray paint coating (24) which fills the spaces between the LED lighting elements, and partially covers the LED lighting elements but with contacts (12,16) of the upwardly facing LED lighting elements exposed and with light output windows formed in the spray paint coating for the upwardly facing LED lighting elements; and
a second conductive layer (28) over the spray paint coating (24) and the exposed contacts (12,16), the second conductive layer being for connection to a second electrical terminal (36).

12. A surface coated with a lighting arrangement as claimed in claim 11, wherein:
the LED lighting elements (10) have a ratio of the square root of the pad area to the pad thickness which is more than 2, for example more than 3, for example more than 4; and/or
the LED lighting elements (10) have an area less than 1 0000(µm)² and a thickness less than 50µm.

13. A surface coated with a lighting arrangement as claimed in claim 11 or 12, wherein the LED lighting elements (10) comprise an optical output cover (18) over the top contact.

14. A surface coated with a lighting arrangement as claimed in any one of claims 10 to 12 further comprising a transparent protective coating over the second conductive layer.

15. A surface coated with a lighting arrangement as claimed in any one of claims 10 to 13, comprising an automobile body panel.

## Patentansprüche

1. Verfahren zum Aufbringen einer Beleuchtungsanordnung auf einer Oberfläche, umfassend:
Bilden einer ersten leitfähigen Schicht (22) über der Oberfläche (20), wobei die leitfähige Schicht zur Verbindung mit einer ersten elektrischen Klemme dient;
Aufbringen einer Anordnung von LED-Beleuchtungselementen (10) über der ersten leitfähigen Schicht, die jeweils ein Pad mit oberem und unterem elektrischen Kontakt (12, 14) umfassen, wobei der obere Kontakt einen vorstehenden Höcker (16) umfasst, wobei die LED-Beleuchtungselemente (10) derart aufgebracht sind, dass mindestens ein Bruchteil von ihnen mit seinen oberen Kontakten (12, 16), die von der Oberfläche weg zeigen, nach oben zeigt;
Sprühfarbenbeschichten zum Füllen der Räume zwischen den LED-Beleuchtungselementen und Abdecken der LED-Beleuchtungselemente mit Sprühfarbe (24);
Entfernen eines oberen Abschnitts der Sprühfarbe (24), um dadurch die Kontakthöcker (16) für die nach oben zeigenden LED-Beleuchtungselemente freizulegen und Lichtausgangsfenster für die nach oben zeigenden LED-Beleuchtungselemente zu bilden, und
Bilden einer zweiten leitfähigen Schicht (28) über der Sprühfarbe und den freigelegten Kontakthöckern, wobei die zweite leitfähige Schicht zum Verbinden mit einer zweiten elektrischen Klemme dient.

2. Verfahren nach Anspruch 1, wobei die erste leitfähige Schicht (22) gesprüht wird.

3. Verfahren nach einem der vorhergehenden Ansprüche, wobei:
die LED-Beleuchtungselemente (10) ein Verhältnis der Quadratwurzel der Pad-Fläche zu der Pad-Stärke haben, das größer ist als 2, zum Beispiel größer als 3, zum Beispiel größer als 4, und/oder
die LED-Beleuchtungselemente (10) eine Fläche kleiner als 10.000 (µm)² und eine Stärke kleiner als 50 µm haben.

4. Verfahren nach einem der vorhergehenden Ansprüche, wobei die LED-Beleuchtungselemente (10) aufgebracht werden, während die erste leitfähige Schicht (22) klebrig ist.

5. Verfahren nach einem der vorhergehenden Ansprüche, wobei die LED-Beleuchtungselemente (10) durch Teilchenstrahlen, Schleudern oder Folientransfer aufgebracht werden.

6. Verfahren nach einem der vorhergehenden Ansprüche, wobei das Entfernen eines oberen Abschnitts Sandstrahlen umfasst.

7. Verfahren nach einem der vorhergehenden Ansprüche, wobei das Bilden der zweiten leitfähigen Schicht (28) das Sprühen einer durchsichtigen leitfähigen Schicht umfasst.

8. Verfahren nach einem der vorhergehenden Ansprüche, das ferner das Aufbringen einer durchsichtigen Schutzbeschichtung über der zweiten leitfähigen Schicht umfasst.

9. Verfahren nach einem der vorhergehenden Ansprüche, wobei die erste leitfähige Schicht (22) gemustert ist, um getrennt adressierbare Bereiche zu definieren.

10. Verfahren nach einem der vorhergehenden Ansprüche, wobei die Oberfläche (20) eine Kraftfahrzeugkarosserieplatte umfasst.

11. Oberfläche, die mit einer Beleuchtungsanordnung beschichtet ist, umfassend:
eine erste leitfähige Schicht (22) über der Oberfläche (20), wobei die erste leitfähige Schicht (22) zum Verbinden mit einer ersten elektrischen Klemme (34) dient;
eine Anordnung von LED-Beleuchtungselementen (10) über der ersten leitfähigen Schicht (22), die jeweils ein Pad mit einem oberen und unteren elektrischen Kontakt (12, 14) umfassen, wobei mindestens ein Bruchteil der LED-Beleuchtungselemente (10) nach oben zeigt, wobei ihre oberen Kontakte (12, 16) von der Oberfläche weg zeigen;
eine Sprühfarbenbeschichtung (24), die die Räume zwischen den LED-Beleuchtungselementen füllt und teilweise die LED-Beleuchtungselemente abdeckt, aber mit Kontakten (12, 16) der nach oben zeigenden LED-Beleuchtungselemente freigelegt und mit Lichtausgangsfenstern, die in der Sprühfarbenbeschichtung für die nach oben zeigenden LED-Beleuchtungselemente gebildet sind, und
eine zweite leitfähige Schicht (28) über der Sprühfarbenbeschichtung (24) und den freigelegten Kontakten (12, 16), wobei die zweite leitfähige Schicht zum Verbinden mit einer zweiten elektrischen Klemme (36) dient.

12. Oberfläche, die mit einer Beleuchtungsanordnung nach Anspruch 11 beschichtet ist, wobei:
die LED-Beleuchtungselemente (10) ein Verhältnis der Quadratwurzel der Pad-Fläche zu der Pad-Stärke haben, das größer ist als 2, zum Beispiel größer als 3, zum Beispiel größer als 4, und/oder
die LED-Beleuchtungselemente (10) eine Fläche kleiner als 10.000 (µm)² und eine Stärke kleiner als 50 µm haben.

13. Oberfläche, die mit einer Beleuchtungsanordnung nach Anspruch 11 oder 12 beschichtet ist, wobei die LED-Beleuchtungselemente (10) eine optische Ausgabeabdeckung (18) über dem oberen Kontakt haben.

14. Oberfläche, die mit einer Beleuchtungsanordnung nach einem der Ansprüche 10 bis 12 beschichtet ist, die ferner eine durchsichtige Schutzbeschichtung über der zweiten leitfähigen Schicht umfasst.

15. Oberfläche, die mit einer Beleuchtungsanordnung nach einem der Ansprüche 10 bis 13 beschichtet ist, die eine Automobilkarosserieplatte umfasst.

## Revendications

1. Procédé d'application d'un agencement d'éclairage à une surface, comprenant :
la formation d'une première couche conductrice (22) sur la surface (20), la couche conductrice servant à se connecter à une première borne électrique ;
l'application d'un réseau d'éléments d'éclairage à DEL (10) sur la première couche conductrice, comprenant chacun un tampon avec des contacts électriques supérieur et inférieur (12, 14), dans lequel le contact supérieur comprend un bossage de contact saillant (16), dans lequel les éléments d'éclairage à DEL (10) sont appliqués de sorte qu'au moins une fraction de ceux-ci soit orientée vers le haut avec leurs contacts supérieurs (12, 16) orientés à l'opposé de la surface ;
le revêtement de peinture par pulvérisation pour remplir les espaces entre les éléments d'éclairage à DEL et couvrir les éléments d'éclairage à DEL avec de la peinture pulvérisée (24) ;
l'élimination d'une portion supérieure de la peinture pulvérisée (24) pour dévoiler ainsi les bossages de contact (16) pour les éléments d'éclairage à DEL orientés vers le haut et pour former des fenêtres de sortie de lumière pour les éléments d'éclairage à DEL orientés vers le haut ; et
la formation d'une seconde couche conductrice (28) sur la peinture pulvérisée et les bossages de contact dévoilés, la seconde couche conductrice servant à se connecter à une seconde borne électrique.

2. Procédé selon la revendication 1, dans lequel la première couche conductrice (22) est pulvérisée.

3. Procédé selon l'une quelconque des revendications précédentes, dans lequel :
les éléments d'éclairage à DEL (10) ont un rapport entre la racine carrée de la superficie de tampon et l'épaisseur de tampon qui est supérieur à 2, par exemple supérieur à 3, par exemple supérieur à 4 ; et/ou
les éléments d'éclairage à DEL (10) ont une superficie inférieure à 10 000 (µm)² et une épaisseur inférieure à 50 µm.

4. Procédé selon l'une quelconque des revendications précédentes, dans lequel les éléments d'éclairage à DEL (10) sont appliqués tandis que la première couche conductrice (22) est collante.

5. Procédé selon l'une quelconque des revendications précédentes, dans lequel les éléments d'éclairage à DEL (10) sont appliqués par projection de particules, jet ou transfert de film.

6. Procédé selon l'une quelconque des revendications précédentes, dans lequel l'élimination d'une portion supérieure comprend le sablage.

7. Procédé selon l'une quelconque des revendications précédentes, dans lequel la formation de la seconde couche conductrice (28) comprend la pulvérisation d'une couche conductrice transparente.

8. Procédé selon l'une quelconque des revendications précédentes, comprenant en outre l'application d'un revêtement protecteur transparent sur la seconde couche conductrice.

9. Procédé selon l'une quelconque des revendications précédentes, dans lequel les contours de la première couche conductrice (22) sont modelés pour définir des régions adressables séparément.

10. Procédé selon l'une quelconque des revendications précédentes, dans lequel la surface (20) comprend un panneau de carrosserie automobile.

11. Surface revêtue d'un agencement d'éclairage, comprenant :
une première couche conductrice (22) sur la surface (20), la première couche conductrice (22) servant à se connecter à une première borne électrique (34) ;
un réseau d'éléments d'éclairage à DEL (10) sur la première couche conductrice (22), comprenant chacun un tampon avec des contacts électriques supérieur et inférieur (12, 14), dans laquelle au moins une fraction des éléments d'éclairage à DEL (10) est orientée vers le haut avec leurs contacts supérieurs (12, 16) orientés à l'opposé de la surface ;
un revêtement de peinture pulvérisée (24) qui remplit des espaces entre les éléments d'éclairage à DEL, et couvre partiellement les éléments d'éclairage à DEL mais avec des contacts (12, 16) des éléments d'éclairage à DEL orientés vers le haut exposés et avec des fenêtres de sortie de lumière formées dans le revêtement de peinture pulvérisée pour les éléments d'éclairage à DEL orientés vers le haut ; et
une seconde couche conductrice (28) sur le revêtement de peinture pulvérisée (24) et les contacts exposés (12, 16), la seconde couche conductrice servant à se connecter à une seconde borne électrique (36).

12. Surface revêtue d'un agencement d'éclairage selon la revendication 11, dans laquelle :
les éléments d'éclairage à DEL (10) ont un rapport entre la racine carrée de la superficie de tampon et l'épaisseur de tampon qui est supérieur à 2, par exemple supérieur à 3, par exemple supérieur à 4 ; et/ou
les éléments d'éclairage à DEL (10) ont une superficie inférieure à 10 000 (µm)² et une épaisseur inférieure à 50 µm.

13. Surface revêtue d'un agencement d'éclairage selon la revendication 11 ou 12, dans laquelle des éléments d'éclairage à DEL (10) comprennent un couvercle de sortie optique (18) sur le contact supérieur.

14. Surface revêtue d'un agencement d'éclairage selon l'une quelconque des revendications 10 à 12, comprenant en outre un revêtement protecteur transparent sur la seconde couche conductrice.

15. Surface revêtue d'un agencement d'éclairage selon l'une quelconque des revendications 10 à 13, comprenant un panneau de carrosserie automobile.
